# EUROPEAN PATENT APPLICATION

(11) **EP 2 042 983 A2**
(43) Date of publication of application: **01.04.2009**
(21) Application number: 08014481.9
(22) Date of filing: 14.08.2008
(51) Int. Cl.: G06F 3/14, G09G 3/32, H01L 25/075

(54) **Modular image display**

(30) Priority: 28.09.2007 PL 38344907
(71) Applicant: RGB Technology Spolka Cywilna, 76-035 Tymien (PL)
(72) Inventor: Nowakowski, Krysztof, 78-320 Polczyn Zdroj (PL); Malyszewicz, Wojciech, 78-111 Ustronie Morskie (PL); Strozyna, Piotr, 78-111 Ustronie Morskie (PL)

(57) **Abstract**

The subject matter of the invention is a modular image display intended for presentation of text images, text and graphic images or graphic images of an information and advertising character, especially in public utility places.

The modular image display possesses, in each module (1), luminous elements (3) configured into triangular pixels (2), which, together with an electronic matrix board (4), are tightly sealed in a strengthening protective layer (5) of plastic. The surface of the protective layer (5) on the display side, among the tops of the luminous elements (3) sticking out of it, is covered by an antireflex film (6).

The control system of each module (1) is equipped with a microprocessor (8). The microprocessors of all modules (1) of the display are connected, through at least one branched power and control node (10), with a data bus (11) led from an external specialised controller (12).

## Description

The subject matter of the invention is a modular image display intended for presentation of text images, text and graphic images or graphic images of an information and advertising character, especially in public utility places.

Widely known displays are the ones in which a colour image is developed as a result of mixing basic RGB colours (Red, Green, Blue) emitted by spot luminous elements, mainly by electroluminescence diodes LED (Light Emitting Diodes). The basic cell of a displayed image, created from the smallest, complete set of luminous elements in RGB colours is a pixel. A pixel in the known displays is most often configured from three to six colour diodes, where, in the cases of the numbers greater than three, some or all RGB colours are doubled. Diodes are arranged on the display surface of the display in columns, with alternate colours, where, in the created rows, neighbouring diodes in RGB colours create a line pixel. Displays in bigger sizes have a modular structure, in which single displays-modules are repeatedly connected with one another.

From the European patent description no. EP1293955, a kind of display is known, in which multiple modules are connected with one another by elastic connectors, forming rows and columns. Individual columns or rows of modules may be tilted from the surface of a display at angles convenient for reading by different groups of viewers. Each module consists of a display section and a control section. A display section is composed of many vertical pipes, made of translucent material. In each pipe a bar is set, which, on the whole length, is equipped with sets of luminous elements - LEDs, linked with power and control system paths, printed on the other side of the bar. Pixels are composed of six diodes arranged linearly, in pairs of RGB colours. The control section consists of a sequence of controllers, to which bars with diodes are connected in pairs. Every three controllers are connected, through a communication connector, with the control signals' bus led from the control computer.

This display has a structure favourably adjusted to the changes of the configuration of modules in different sizes, however, it is characterised by a very unfavourable, complicated, multi-element structure of a display section, while the control section, based on the idea of parallel transmission of control signals to successive pairs of bars with luminous elements, includes a relatively great number of controllers and multi-core cables.

A significantly simpler solution to a display is known from the description of the Polish patent application no. 372635. The module of a display includes light emitting diodes (LEDs) arranged regularly in columns on the matrix board with an electronic control system. The matrix board, set in a carrying frame, is encased by screen plates, where the rear one is opaque and the front one is made of the material shining the light through. The control system includes shift register blocks, composed of cascadely connected sequential systems, in which the output of data from one sequential system is led to the input of the next one. Each sequential system designated to control one column of diodes, includes an integrated circuit, which is connected with the diodes in the column through resistors. The number of resistors equals the number of diodes. To each sequential system, control signals' inputs are led from the external specialised microprocessor controller. Control signals from the controller are transmitted to respective sequential systems, from where the integrated circuit, through appropriate resistors, turns the power of a chosen group of diodes on or off, which, in consequence, leads to displaying a required image.

The inconvenience of such kind of display is, used in the casing, a smooth glassy screen plate protecting the diode luminous elements, which, reflecting sunlight or the image of a bright sky, diminishes the visibility of a displayed image. Moreover, the structure of the casing impedes the extension of the overall dimensions of the display and does not secure full protection for fragile electronic elements against the influence of extremely adverse environmental conditions.

In the known display, the ability to extend its overall dimensions, resulting from the applied control system solution, is limited. The extension of the display, by multiplying shift register blocks, entails parallel leading of subsequent and longer and longer cables from subsequent blocks to the controller, which entails a bigger sensitivity of the system to interferences. The failure of the controller or of one of the register blocks causes the immobilisation of the whole display.

The aim of the invention is a modular display, characterised by resistance to the influence of environmental conditions, simple construction, efficient control and better physical resolution of a displayed image.

The aim has been achieved in the modular display according to the invention, in which each module possesses luminous elements put together into triangular pixels, arranged regularly on an electronic matrix board, which, at least on the display side, favourably on both sides, is tightly sealed in a strengthening protective layer of plastic. On the display side, the surface of the protective layer, among the tops of the luminous elements sticking out of it, is covered with an antireflex film.

The modular display, according to the invention, possesses, in the control system of each module, a microprocessor, linked with the internal shift register blocks, controlling the luminous elements of the pixels. The microprocessors of all modules of the display are connected, through at least one branched power and control node, with a data bus led from an external specialised controller, favourably from a computer.

A favourable result of the invention is improved mixing of the colours of the luminous elements, causing that the observer does not see each colour separately, but uniform colour pixels. The elements of the electronic system, sealed in the protective layer, are effectively protected against dampness and mechanical damages, without the need of using a glassy screen plate, which, with the simultaneous application of the antireflex film, causes the elimination of light reflections and the improvement of the visibility of a displayed image. The processor applied in each module shortens the flow paths of control signals between this processor and the luminous elements, which immunises the electronic systems against interferences. Connecting the microprocessors of particular modules with the external controller through the node and the data bus, enables a serial transmission of data by means of cheap two-core cables, through less unreliable small-contact connectors, and makes the operation of particular modules independent, and also allows the extension of the display by subsequent modules.

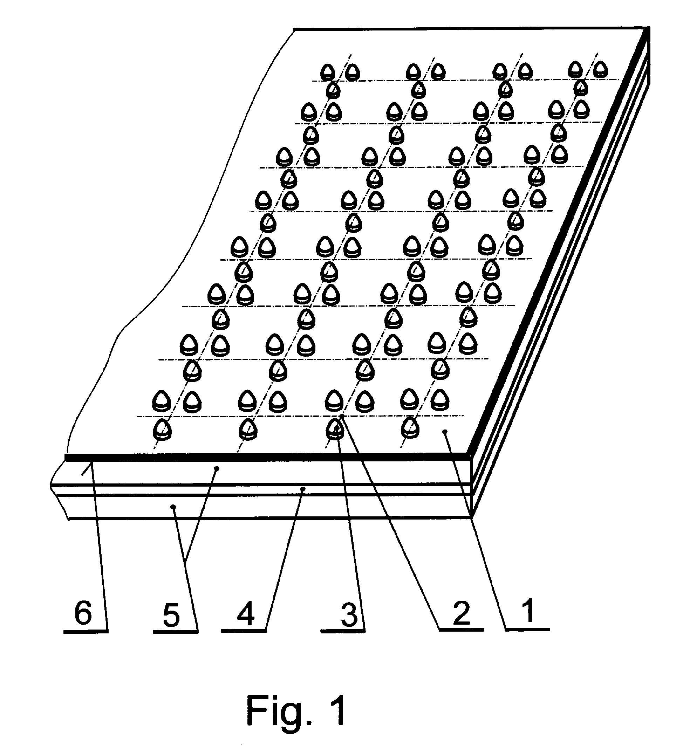

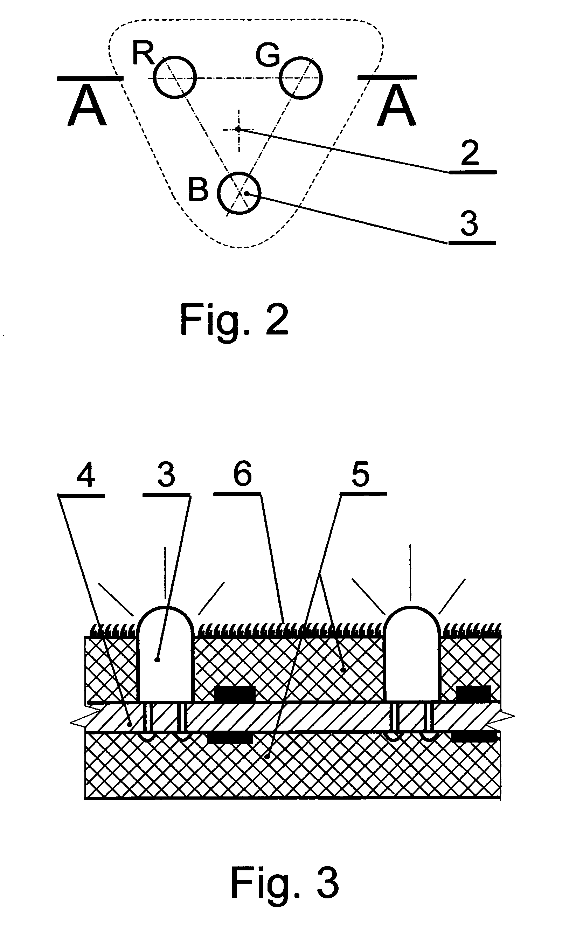

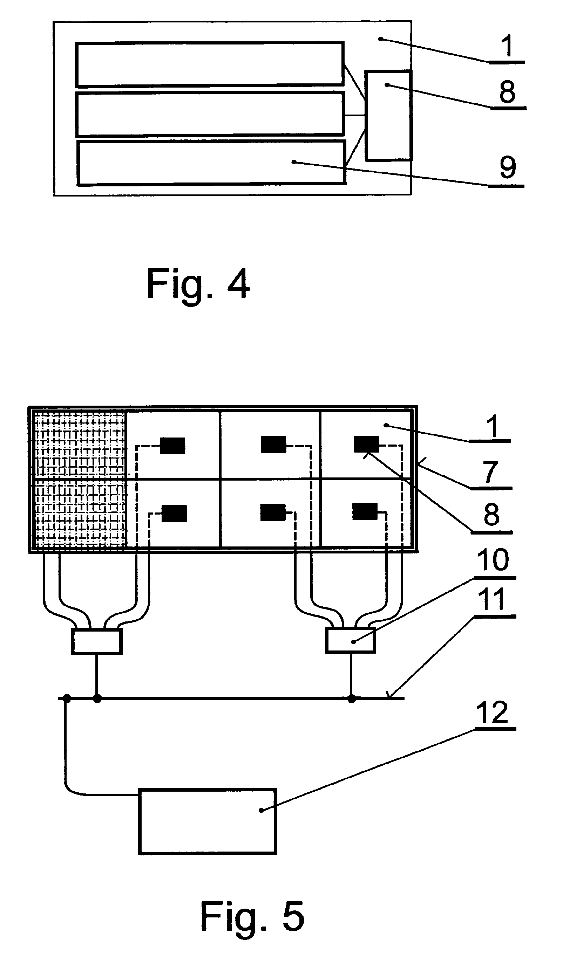

The subject matter of the invention is shown more precisely by the execution example in the picture, in which fig. 1 shows a fragment of the display module panel in a perspective view, fig. 2 shows the configuration of one pixel on the module panel, fig. 3 shows section A-A with fig. 2, fig. 4 shows the flow chart of the control system in the module, and fig. 5 shows the diagram of the display modules' connections with the external specialised controller.

The module display is composed of modules 1, each of which has features of an independent display. In the set including more than one module 1, they are connected with one another to form a uniform display surface, both in horizontal and in vertical arrangement. The modules 1 are integrated into a uniform display by means of a carrying frame 7. In this execution example, the display is composed of eight modules 1, put together in two rows. In a frontal view, each module 1 has the shape of a quadrangular panel, on which, on the display side, pixels 2, arranged regularly on its whole surface, are visible. Each pixel 2 consists of three luminous elements 3 (LEDs), each one in a different RGB colour. In another execution example, diodes may be in one colour. The luminous elements 3 are fixed to an electronic matrix board 4 and are connected with its printed power and control circuits, while the places of destination of the luminous elements 3 of each pixel 2 are determined by the vertexes of the triangle. The electronic matrix board 4 is tightly sealed on both sides in a strengthening protective layer 5 of plastic on the basis of self-hardening epoxy resins. The thickness of the protective layer 5 is a bit smaller than the height of the luminous elements 3, thanks to which their tops are visible above the protective layer surface 5. On the display side, the protective layer 5, among the sticking out tops of the luminous elements 3, is covered by an antireflex film 6 of a rough structure in a dark matt colour.

The control system of each module 1 is equipped with a microprocessor 8, with which shift register blocks 9 for the luminous elements 3 control are linked. The microprocessors 8 of groups including four modules 1 each are connected by cables, in a star layout, to branched power and control nodes 10. The nodes 10 of successive module groups 1 are connected in parallel with a data bus 11, led from an external specialised controller 12, in the form of a computer.

Control data from the controller 12 to the modules 1 are transmitted in series. The control signals sent by the controller 12 are equipped with program addresses of the individual modules 1. The microprocessors 8 in the modules 1 recognise and receive control signals meant for them and process them from the received serial form into a form controlling the shift register blocks 9 which control the power supply of the appropriate luminous elements 3.

## Claims

1. The modular image display, including at least one module, equipped, on the display side, with spot luminous elements, configured into pixels, linked with an electronic matrix board and protected against environmental effect, the characteristic feature of which is that the luminous elements (3) of each pixel (2) are configured into a triangle, which elements, together with the electronic matrix board (4), at least on the display side, favourably on both sides, are tightly sealed in a strengthening protective layer (5) of plastic.

2. The modular image display according to claim 1, the characteristic feature of which is that the surface of the protective layer (5) on the display side, among the tops of the luminous elements (3) sticking out of it, is covered by an antireflex film (6).

3. The modular image display, including at least one module with an electronic control system, composed of shift register blocks for luminous elements control connected with an external specialised controller, the characteristic feature of which is that the control system of each module (1) is equipped with a microprocessor (8), with which the shift register blocks (9) are linked, while the microprocessors (8) of all modules (1) of the display are connected, through at least one branched power and control node (10), with a data bus (11) led from the external specialised controller (12), favourably a computer.
